Europäisches Patentamt

European Patent Office

Office européen des brevets

(11) Publication number: **0 098 984**
A1

# EUROPEAN PATENT APPLICATION

(21) Application number: 83105812.8

(22) Date of filing: 14.06.83

(51) Int. Cl.³: **G 03 B 41/00**

(30) Priority: 18.06.82 US 389678
07.01.83 US 456494

(43) Date of publication of application:
25.01.84 Bulletin 84/4

(84) Designated Contracting States:
DE FR GB IT

(71) Applicant: EATON-OPTIMETRIX INC.
500 Ellis Street
Mountain View California 94043(US)

(72) Inventor: Phillips, Edward H.
P.O. Box 1042
Middletown, CA. 95461(US)

(74) Representative: Liesegang, Roland, Dr.-Ing.
Sckellstrasse 1
D-8000 München 80(DE)

(54) Step-and-repeat projection alignment and exposure system.

(57) A projection lens (26) and a source (24 or 164) of
illumination and exposure light are employed for projecting
an image of a reticle (12) onto a first reference mark (32) or a
semiconductive wafer (14), both of which are movably
supported in the image plane of the projection lens (26).
Optical apparatus (46 or 234), including a source of nonexpo-
sure light (108), is provided and is operable with the
projection lens (26) for imaging a second adjustable refer-
ence mark (116) onto the first reference mark (32) or the
semiconductive wafer (14) to facilitate use of the projection
lens (26) in aligning a semiconductive wafer (14) covered
with a photoresist opaque to exposure light. Additional
optical apparatus (200, 214, 216a & 216b), including an
objective lens unit (214) and an imaging lens (200), may be
provided for imaging light from the source (164) of illumina-
tion and exposure light at the reticle (12) and for reimaging
reflected light from the semiconductive wafer (14) at the
objective lens unit (214).

Fig 1

0098984

BORE-SIGHTED STEP-AND-REPEAT PROJECTION

ALIGNMENT AND EXPOSURE SYSTEM


Background and Summary of the Invention

This invention relates generally to step-and-repeat
alignment and exposure systems for aligning each of an
array of different regions of a first object, such as
a semiconductive wafer, with respect to an image of a
second object, such as a reticle, and for photometrically
printing that image at each of those regions by employing
a projection lens of the reduction type. More specifically,
this invention relates to improved optical apparatus for
use in such systems to facilitate utilization of the
projection lens in aligning each region of the semiconductive
wafer with respect to the image of the reticle.

In European Patent Applications Nos. 80 101 307.9 and
81 100 559.4 improved step-and-repeat alignment and exposure
systems are disclosed that may be employed for aligning each
of an array of inchoate dice regions of a semiconductive
wafer with respect to an image of a main reticle containing
a level of microcircuitry to be photometrically printed at
each of those inchoate dice regions. Each system includes
a main stage movable along orthogonal axes of motion of the
system, a substage mounted on the main stage for aligning a
reference mark with respect to the orthogonal axes of motion
of the system, a rotatable vacuum chuck mounted on the main
stage for holding the semiconductive wafer, a reticle stage
mounted above the main stage for holding the main reticle,
and a projection lens disposed between the main stage and the
reticle stage and operable with an associated beam splitter and an associated split-field objective lens unit for directly viewing the image of the main reticle and also the reference mark or the semiconductive wafer depending on the position of the main stage.

Thus, while employing the projection lens and its associated split-field objective lens unit to directly view the image of the main reticle and also the reference mark, the main stage and the substage can be employed to align the reference mark with respect to the orthogonal axes of motion of the system during a reference mark set-up alignment operation, and the main stage and the reticle stage can thereafter be employed to align images of global alignment marks disposed at opposite sides of the main reticle with respect to corresponding portions of the reference mark and, hence, with respect to the orthogonal axes of motion of the system during a main reticle alignment operation. Similarly, while subsequently employing the projection lens and its associated split-field objective lens unit to directly view the image of the main reticle and also the semiconductive wafer, the main stage can be employed to alternately align global alignment marks disposed at opposite sides of the semiconductive wafer with respect to the images of the global alignment marks of the main reticle to align the semiconductive wafer as a whole with respect to the orthogonal axes of motion of the system during a global wafer alignment operation, and thereafter to align local alignment marks disposed between selected ones of the inchoate dice regions of the semiconductive wafer with respect to an image of a corresponding local alignment mark on the main reticle to more precisely align each inchoate dice region with respect to the image of the main reticle during a precision region-by-region or local wafer alignment operation.

The projection lens is corrected for exposure light (namely, blue light having a wavelength of 436 nanometers) so that the projection lens can be employed to photometrically print the level of microcircuitry contained on the main reticle at each inchoate dice region of the semiconductive wafer, once that region is aligned with respect to the image of the main reticle, in precise alignment with other previously or yet-to-be printed levels of microcircuitry by exposing a photoresistive film on that region in accordance with that image during a wafer exposure operation. A controllable light source unit, an associated plurality of masking elements, another beam splitter, and an imaging lens disposed between that beam splitter and the main reticle are provided for selectively illuminating different portions of the main reticle with exposure light so that the global and local alignment marks of the semiconductive wafer can be illuminated with exposure light during the global and precision local wafer alignment operations performed with the projection lens and its associated split-field objective lens unit without exposing the photoresistive film on each inchoate dice region. However, due to interference patterns that may be created for some photoresistive films or other surface conditions of the semiconductive wafer at the wavelength of the exposure light for which the projection lens is corrected, it is often desirable to employ a photoresistive film that is opaque to the exposure light. In this case the projection lens and its associated split-field objective lens unit cannot be employed in performing the global and precision local alignment operations.

As disclosed in each of the aforementioned patent applications, the controllable light source unit can be adjusted to selectively illuminate the reticle with nonexposure light of longer wavelength (namely, green light having a wavelength of 546 nanometers), and a compensating lens can be moved into position to compensate the projection lens for the nonexposure light of longer wavelength during the global and precision local wafer alignment operations involving a photoresistive film that is opaque to the exposure light. However, a disadvantage of this technique is the loss of time in adjusting the controllable light source unit and moving the compensating lens into position for the global and precision local wafer alignment operations and thereafter readjusting the controllable light source unit and moving the compensating lens back out of position for the wafer exposure operation. Moreover, the image plane of the projection lens may be shifted by the compensating lens, thereby resulting in the possibility of alignment errors.

In European Patent Application No. 81 100 559.4 an auxiliary optical unit is disclosed that may be employed in performing the global and precision local alignment operations when the projection lens and its associated split-field objective lens unit cannot be so employed due, for example, to the use of a photoresistive film that is opaque to the exposure light. This auxiliary optical unit is disposed above the main stage and offset from the projection lens along one of the orthogonal axes of motion of the system. The auxiliary optical unit includes an adjustable auxiliary reticle containing an alignment mark, a source of white light

-4-

for illuminating the auxiliary reticle, and an auxiliary objective lens unit for directly viewing an image of the alignment mark of the auxiliary reticle and also either the reference mark or the semiconductive wafer depending on the position of the main stage.

Thus, while employing the auxiliary objective lens unit to directly view the image of the alignment mark of the auxiliary reticle and also the reference mark, the main stage and the adjustable auxiliary reticle can be employed to align the alignment mark of the auxiliary reticle with respect to the reference mark and, hence, with respect to the orthogonal axes of motion of the system and thereby also measure the offset between the projection lens and the auxiliary objective lens unit during an auxiliary reticle set-up alignment operation. While thereafter employing the auxiliary objective lens unit to directly view the image of the alignment mark of the auxiliary reticle and also the semiconductive wafer, the main stage can be employed to align each global alignment mark of the semiconductive wafer with respect to the image of the alignment mark of the auxiliary reticle and, hence, with respect to the orthogonal axes of motion of the system during the global wafer alignment operation and subsequently to align each local alignment mark of the semiconductive wafer with respect to the image of the alignment mark of the auxiliary reticle during the precision local wafer alignment operation. The main stage can thereupon be moved to coordinate positions determined by the measured offset between the projection lens and the auxiliary objective lens unit so that the projection lens may be employed to photometrically print the level of

-5-

microcircuitry contained on the main reticle at each inchoate dice region of the semiconductive wafer.

A disadvantage of such an auxiliary optical unit is the loss of time in having to move the main stage by the offset between the projection lens and the auxiliary objective lens unit to perform the global and precision local wafer alignment operations and the additional loss of time in having to move the stage by the same offset to perform the wafer exposure operation. Moreover, the possibility of alignment errors is increased due to the necessity of moving the stage by that offset between the wafer alignment and the wafer exposure operations.

Accordingly, it is an object of this invention to provide improved optical apparatus for enabling the projection lens of a step-and-repeat alignment and exposure system, such as, for example, those described above, to be employed in performing the global and precision local wafer alignment operations even when a photoresistive film opaque to exposure light of the wavelength for which the projection lens is corrected is disposed on each inchoate dice region of the semiconductive wafer.

Another object of this invention is to provide an improved step-and-repeat alignment and exposure system in which a projection lens, employed for photometrically printing a level of microcircuitry on a semiconductive wafer covered with a photoresistive film opaque to the wavelength of exposure light for which the projection lens is corrected, can be employed in performing the global and precision local wafer alignment operations, as well as the wafer exposure operation, without the necessity of employing a controllable light source unit for selectively illuminating different portions of the main reticle with the exposure light, without the necessity of adjusting the controllable light source unit to selectively illuminate the main reticle with nonexposure light of longer wavelength and concomitantly employing a compensating lens to compensate the projection lens for the nonexposure light, and without the necessity of moving the stage by an offset distance to perform the global and precision local wafer alignment operations or the wafer exposure operation.

Still another object of this invention is to provide an improved step-and-repeat alignment and exposure system as in the last object in which, like European Patent Application No. 81 100 206.2, the entire field viewed on the semiconductive wafer by an objective lens unit associated with the projection lens is illuminated by nonexposure light that is of longer wavelength than the exposure light, that does not pass through any reticle, and that does not illuminate the entire semiconductive wafer.

These and other objects, which will become apparent from a reading of this specification and an inspection of the accompanying drawings, are accomplished according to one illustrated embodiment of this invention by employing a split-field objective lens unit, operable with a nonchromatic beam splitter, the projection lens, and a source (employed in place of the controllable light source unit) of exposure light of a wavelength for which the projection lens is corrected, for directly viewing images of the global alignment marks of the main reticle and also the corresponding portions of the reference mark to facilitate alignment of the images of those global alignment marks with respect to the reference

-7-

mark during the main reticle alignment operation; by employing a first single-channel objective lens unit, operable with a chromatic beam splitter, the nonchromatic beam splitter, the projection lens and the source of exposure light, for directly viewing an image of another alignment mark disposed on the main reticle between the global alignment marks and also a corresponding portion of the reference mark to facilitate alignment of that corresponding portion of the reference mark with respect to the image of the other alignment mark of the main reticle; and by employing an adjustable alignment reticle and a second single-channel objective lens unit, operable with both the chromatic and nonchromatic beam splitters, the projection lens and a first source of nonexposure light of longer wavelength than the exposure light, for imaging an alignment mark of the alignment reticle at the image plane of the projection lens and for directly viewing the image of that alignment mark and also a corresponding portion of the reference mark to facilitate adjustment of the alignment reticle to align the image of that alignment mark with respect to that corresponding portion of the reference mark and, hence, with respect to the image of the other alignment mark of the main reticle in a bore-sighting alignment reticle set-up alignment operation. This bore-sighting alignment reticle set-up alignment operation can be repeated as frequently as desired during the operation of the step-and-repeat alignment and exposure system to maintain the alignment accuracy of the system.

Following the bore-sighting alignment reticle set-up alignment operation, the second single-channel objective lens unit can be employed for directly viewing the image

0098984

of the alignment mark of the alignment reticle and also each global alignment and local alignment mark of the semiconductive wafer to facilitate alignment of each of those alignment marks of the semiconductive wafer with respect to the image of the alignment mark of the alignment reticle during the global and precision local wafer alignment operations. Additional optical apparatus, including an apertured field-stop plate and a second source of nonexposure light of the same wavelength as the first source of nonexposure light, is employed for illuminating the entire field viewed in the image plane of the projection lens by the second single-channel objective lens unit with the nonexposure light to facilitate locating the global alignment marks of the semiconductive wafer during the global wafer alignment operation.

A disadvantage of the foregoing embodiment of this invention and of the previously-described step-and-repeat projection alignment and exposure systems is that the nonchromatic beam splitter associated with each split-field objective lens unit is not a commercially available off-the-shelf part. Concomittantly, neither the projection lens nor either split-field objective lens unit is a commercially available off-the-shelf part. Moreover, the optical portions of the foregoing systems are relatively complex, and different light sources are employed for alignment and exposure operations resulting in possible misalignments due to different intensity distributions of those light sources.

Accordingly, another object of this invention is to provide an improved step-and-repeat projection alignment and exposure system in which the need for the aforementioned

-9-

nonchromatic beam splitter is eliminated and in which a commercially available off-the-shelf projection lens and a commercially available off-the-shelf split-field objective lens unit can be employed.

Another object of this invention is to provide a step-and-repeat projection alignment and exposure system, such as any of the aforementioned systems, with improved and simplified optical apparatus for use in performing the aforementioned reticle and wafer alignment operations.

Another object of this invention is to provide an improved step-and-repeat projection alignment and exposure system in which one light source is employed for both alignment and exposure operations, thereby eliminating possible misalignments due to different intensity distributions of different light sources.

These and other objects, which will become apparent from a reading of this specification and an inspection of the accompanying drawings, are accomplished according to another illustrated embodiment of this invention by employing a source of exposure light including a shutter with a neutral density filter operable, when the shutter is closed, for passing enough exposure light to illuminate the main reticle without exposing the photoresistive film on the semiconductive wafer; by replacing the beam splitter disposed between the main reticle and the projection lens with a cold mirror disposed for reflecting exposure light from the source of exposure light and for transmitting nonexposure light from first and second sources of nonexposure light; by replacing the split-field objective lens unit operable with the replaced nonchromatic beam splitter with a split-field

0098984

objective lens unit operable with the other beam splitter and the imaging lens, mentioned above in connection with the systems disclosed in European Patent Applications Nos. 80 101 307.9 and 81 100 559.4, for directly viewing an image of illuminated portions of the main reticle and the reference mark or the semiconductive wafer; and by employing a silicon intensified TV camera and an associated TV monitor for displaying that image.

### Description of the Drawings

Figure 1 is an isometric view of a step-and-repeat alignment and exposure system according to one embodiment of this invention.

Figure 2 is a plan view of a reference mark formed on a substage of a main stage of the system of Figure 1 or Figures 11A and 11B.

Figure 3 is a plan view of a first level main reticle employed in the system of Figure 1 or Figures 11A and 11B to allow photometric step-and-repeat printing of a first level of microcircuitry contained on that main reticle onto a semiconductive wafer.

Figures 4A and 4B are plan views of second or higher level main reticles employed in the system of Figure 1 or Figures 11A and 11B to allow photometric printing of a second or higher level of microcircuitry contained on those main reticles onto a semiconductive wafer coated with a positive photoresist and onto a semiconductive wafer coated with a negative photoresist, respectively.

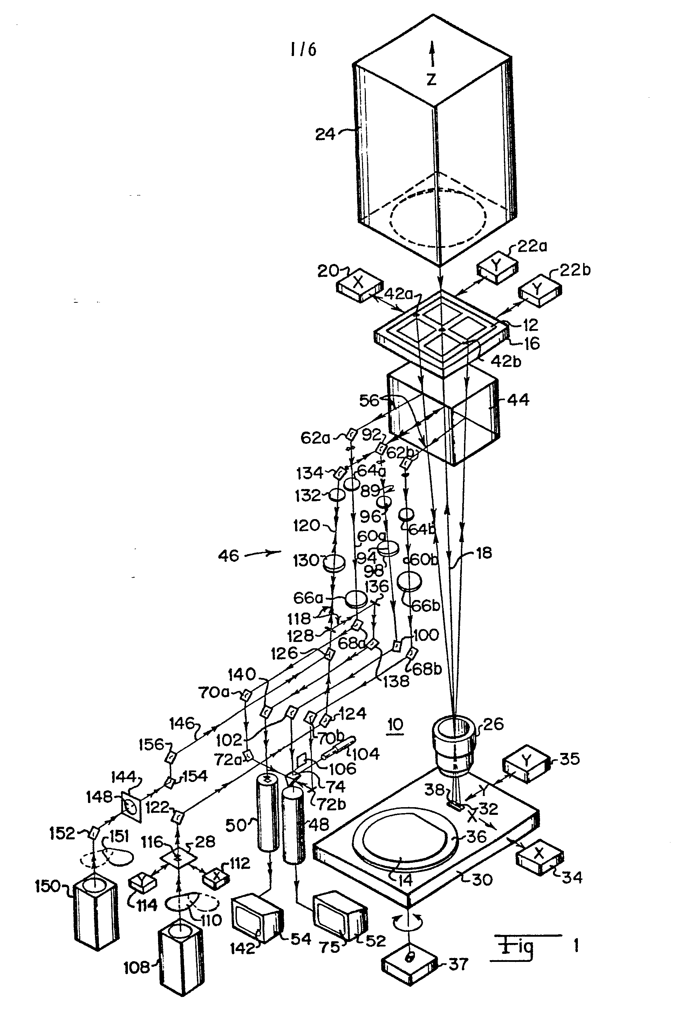

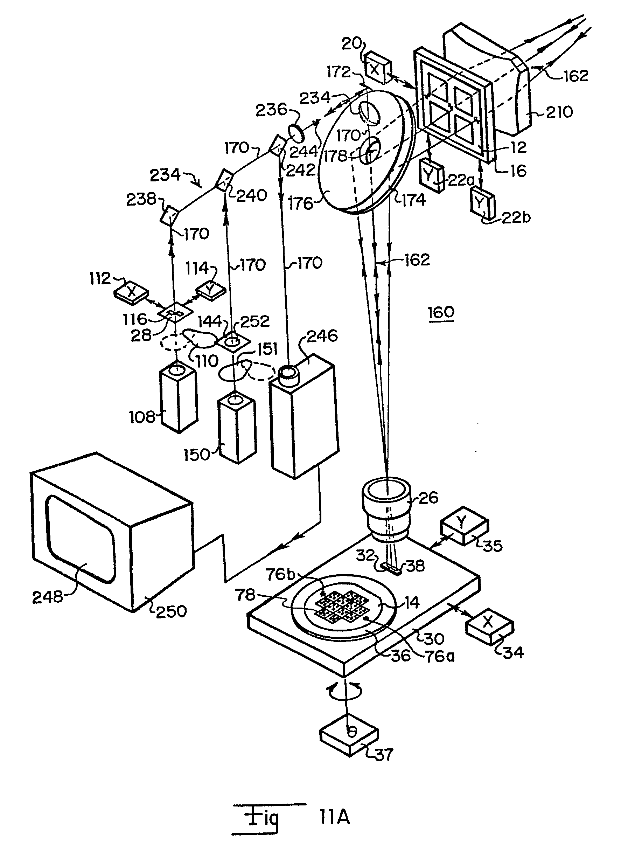

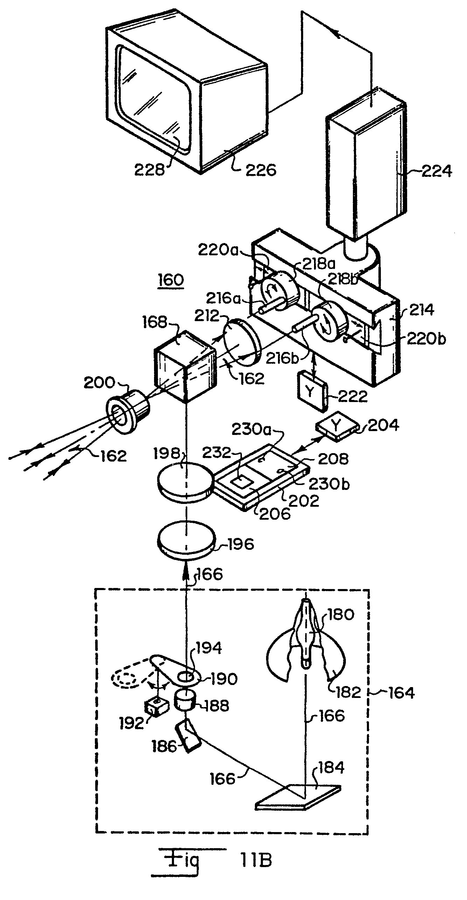

Figure 5 is a split-field view of portions of the reference mark illuminated by images of a pair of global

-11-

alignment marks of a first or higher level main reticle as viewed on the face of a first TV monitor of the system of Figure 1 or Figures 11A and 11B.

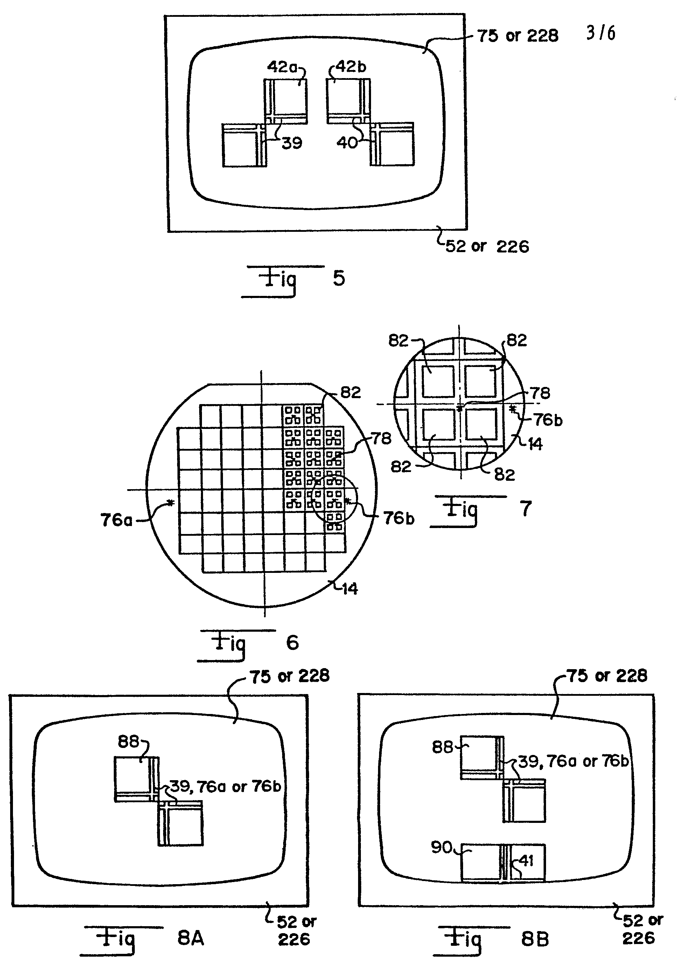

Figure 6 is a plan view of a semiconductive wafer employed in the system of Figure 1 or Figures 11A and 11B.

Figure 7 is an enlarged plan view of a portion of the semiconductive wafer of Figure 6 or Figures 11A and 11B.

Figures 8A and 8B are views of portions of the reference mark illuminated by an image of another alignment mark of a main reticle used for positive photoresists and by an image of another alignment mark of a main reticle used for negative photoresists, respectively, as viewed on the face of the first TV monitor of the system of Figure 1 or Figures 11A and 11B.

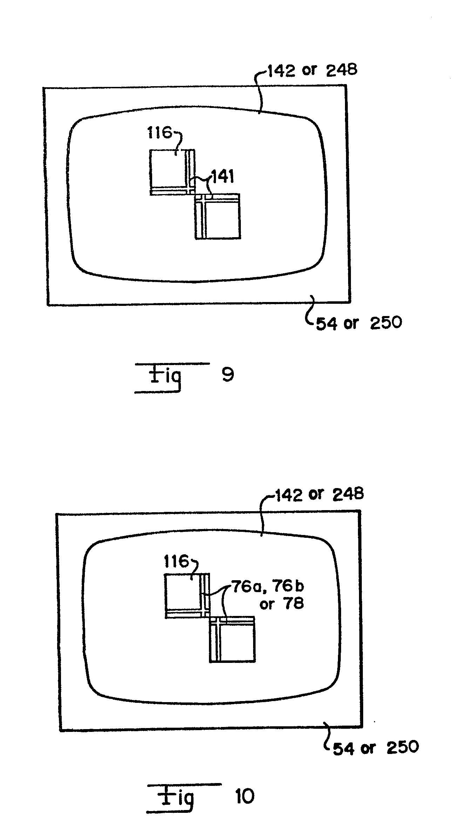

Figure 9 is a view of a portion of the reference mark illuminated by an image of an alignment mark of an alignment reticle of the system of Figure 1 or Figures 11A and 11B as viewed on the face of a second TV monitor of the system.

Figure 10 is a view of a global or local alignment mark of a semiconductive wafer being aligned in the system of Figure 1 or Figures 11A and 11B as illuminated by the image of the alignment mark of the alignment reticle and as viewed on the face of the second TV monitor of the system.

Figures 11A and 11B comprise an isometric view of a step-and-repeat projection alignment and exposure system according to another embodiment of this invention.

## Description of the Preferred Embodiments

Referring now to Figure 1, there is shown a precision step-and-repeat alignment and exposure system 10, according to one of the preferred embodiments of this invention, for repeatedly photometrically printing a level of microcircuitry contained on a first object, such as a main reticle 12, at an array of adjacent regions of a second object, such as a semiconductive wafer 14, in alignment with other levels of microcircuitry previously printed or yet to be printed at each of those same regions. In this system 10 a reticle stage 16 is employed for holding the main reticle 12 along a vertical optical path 18 of the system. The reticle stage 16 may be moved along orthogonal X and Y axes and rotated about an orthogonal Z axis of the system 10 by an X-axis servo drive unit 20 and a pair of differential Y-axis servo drive units 22a and 22b coupled to the reticle stage. An exposure light source 24 is disposed along the vertical optical path 18 above the reticle stage 16 and employed for illuminating the main reticle 12 with, for example, blue exposure light having a wavelength of 436 nanometers. The exposure light source 24 includes a shutter and an adjustable shadow mask of conventional design (not shown). A 10:1 reduction type projection lens 26 is disposed along the vertical optical path 18 below the reticle stage 16 and employed for projecting an image of the illuminated main reticle into an image plane of the projection lens during alignment and exposure operations hereinafter described. The projection lens 26 is also employed for projecting an image of an adjustable alignment reticle 28, which is illuminated by, for example, yellow nonexposure light having a wavelength

-13-

of 577 nanometers, into the same image plane during alignment operations hereinafter described.

A main stage 30 is disposed below the projection lens 26 and employed for positioning the semiconductive wafer 14 or a reference mark 32 in the image plane of the projection lens along the vertical optical path 18 and with respect to the projected images of the illuminated main reticle 12 or of the illuminated alignment reticle 28. The main stage 30 may be moved along the orthogonal X and Y axes of the system 10 by an X-axis servo drive unit 34 and a Y-axis servo drive unit 35 coupled to the main stage. A rotatable vacuum chuck 36 for holding the semiconductive wafer 14 is mounted on the main stage 30. The vacuum chuck 36 may be rotated about an axis parallel to the Z axis of the system by a θ servo drive unit 37 coupled to the vacuum chuck.

The reference mark 32 may be formed of bright chrome on a substage 38 of the main stage 30. As fully explained in European Patent Application No. 80 101 307.9, the substage 38 may be employed to pivot the reference mark 32 with respect to the image plane of the projection lens to precisely position the reference mark in and parallel to that image plane and may be further employed to pivot the reference mark with respect to a plane orthogonal to the image plane of the projection lens to precisely align the reference mark with respect to the orthogonal X and Y axes of motion of the system 10. Once the reference mark 32 is so aligned it serves as a visual indication of the orthogonal X and Y axes of motion of the system 10 and thereby facilitates use of those axes of motion as an absolute frame of reference for the system.

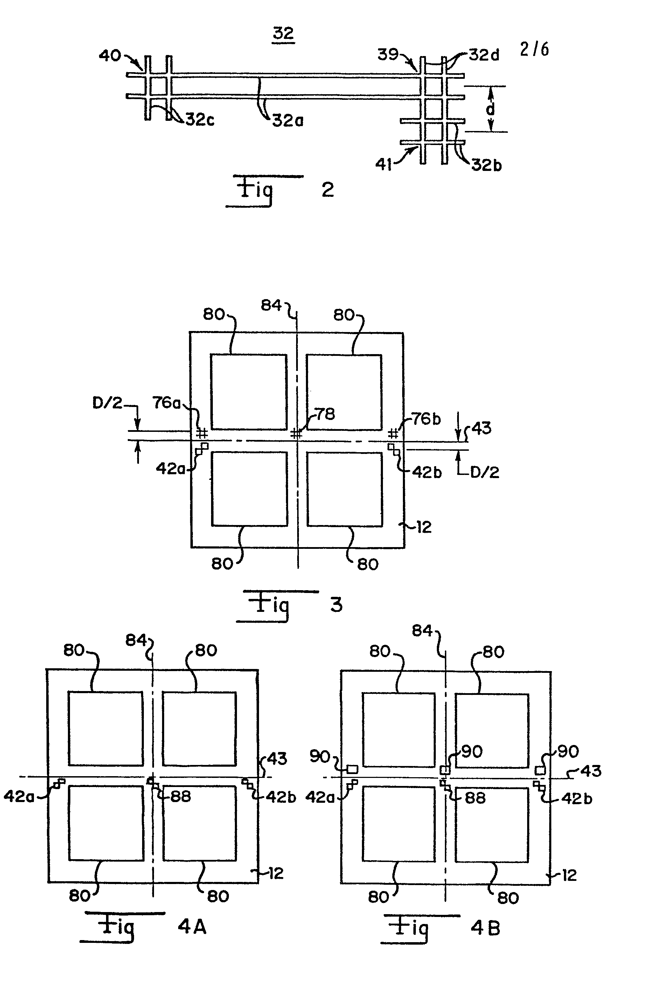

As shown in Figure 2, the reference mark 32 may comprise a first pair of parallel lines 32a and a second pair of shorter parallel lines 32b disposed adjacent to and spaced a finite center-to-center distance d (for example, 100 microns) from the right-hand end of the first pair of parallel lines. All of these parallel lines 32a and 32b are to be aligned with respect to the X axis of motion of the system 10. The reference mark 32 may further comprise a left-hand pair of parallel tic marks 32c orthogonally intersecting the left-hand end portion of the first pair of parallel lines 32a to form a left-hand, double-cross alignment mark 40, and a right-hand pair of longer parallel tic marks 32d orthogonally intersecting both the right-hand end portion of the first pair of parallel lines 32a and the adjacent second pair of parallel lines 32b to form two right-hand, double-cross alignment marks 39 and 41, respectively. Alignment of the parallel lines 32a and 32b with respect to the X axis of motion of the system 10 automatically aligns all of the tic marks 32c and 32d with respect to the Y axis of motion of the system.

The pair of right-hand and left-hand double-cross alignment marks 39 and 40 are employed for aligning an image of a corresponding pair of global alignment marks 42a and 42b contained on the main reticle 12 during a main reticle alignment operation hereinafter explained. A pair of such global alignment marks 42a and 42b is contained on every first-level main reticle 12, as shown in Figure 3, and also on every second-level and higher-level main reticle, as shown in Figures 4A and 4B. On each main reticle 12 the

-15-

global alignment marks 42a and 42b are disposed in marginal areas adjacent to opposite sides of the main reticle and spaced a finite center-to-center distance D/2 (for example, 500 microns) below a centerline 43 of the main reticle. The global alignment marks 42a and 42b may each comprise a pair of light or transparent windows on a dark or opaque field as fully explained in European Patent Application No. 81 100 559.4.

Referring again to Figure 1, a nonchromatic beam splitter 44 is disposed along the vertical optical path 18 between the reticle stage 16 and the projection lens 26 to provide a port for direct viewing of aerial images of portions of the reference mark 32 or of the semiconductive wafer 14 illuminated by the projected images of the illuminated main reticle 12 or of the illuminated alignment reticle 28. An objective optical system 45 is disposed adjacent to this port and employed with the nonchromatic beam splitter 44 and the projection lens 26 to project the image of the illuminated alignment reticle 28 into the image plane of the projection lens. This objective optical system 46 is further employed with the nonchromatic beam splitter 44, the projection lens 26, first and second TV picture tubes 48 and 50, and associated first and second TV monitors 52 and 54 to view the aerial images of the portions of the reference mark 32 and of the semiconductive wafer 14 illuminated by the projected images of the illuminated main reticle 12 and of the illuminated alignment reticle 28.

The objective optical system 46 includes a dual-channel or split-field objective lens unit 56 for viewing

-16-

an aerial image of the double-cross alignment marks 39 and 40 of the reference mark 32 as illuminated by projected images of the illuminated global alignment marks 42a and 42b of the main reticle 12. This aerial image is formed by the blue exposure light projected downwardly along the vertical optical path 18 from exposure light source 24 through global alignment marks· 42a and 42b of the main reticle 12, a rectangular clearance opening in reticle stage 16, nonchromatic beam splitter 44 and projection lens 26 to the image plane of the projection lens where the double-cross alignment marks 39 and 40 of the reference mark 32 are illuminated. Twenty percent of the blue exposure light reflected upwardly back along the vertical optical path 18 from these illuminated portions of the reference mark 32 and through the projection lens 26 is reflected by the nonchromatic beam splitter 44 along first horizontally-extending portions of a dual optical path 60a and 60b of the system 10.

The split-field objective lens unit 56 includes a pair of beam benders 62a and 62b disposed along the first horizontally-extending portions of the dual optical path 60a and 60b for deflecting the reflected blue exposure light downwardly along first vertically-extending portions of the dual optical path through a pair of infinity-corrected objective lenses 64a and 64b and a pair of imaging lenses 66a and 66b to another pair of beam benders 68a and 68b. These pairs of beam benders 62a and 62b, infinity-corrected objective lenses 64a and 64b, imaging lenses 66a and 66b, and beam benders 68a and 68b provide a pair of pivotally and longitudinally adjustable periscopes, as fully explained

-17-

in European Patent Application No. 80 101 307.9, to accommodate both horizontal and vertical adjustment of the split-field objective lens unit 56. The pair of beam benders 68a and 68b is disposed for deflecting the reflected blue exposure light forwardly along second horizontally-extending portions of the dual optical path 60a and 60b to another pair of beam benders 70a and 70b, which is in turn disposed for deflecting the reflected blue exposure light downwardly along second vertically-extending portions of the dual optical path to still another pair of beam benders 72a and 72b. This pair of beam benders 72a and 72b is disposed for deflecting the reflected blue exposure light laterally along third horizontally-extending portions of the dual optical path 60a and 60b to a corresponding pair of faces of a split-field prism 74. The split-field prism 74 is disposed for deflecting the reflected blue exposure light from each of those faces in side-by-side relationship downwardly along a common third vertically-extending portion of the dual optical path 60a and 60b to the face of the first TV picture tube 48. This first TV picture tube 48 is coupled to the first TV monitor 52 so as to provide a split-field veiw of the aerial image of the double-cross alignment marks 39 and 40 of reference mark 32 as illuminated by the projected images of the illuminated global alignment marks 42a and 42b of the main reticle 12, as shown in Figure 5.

While observing this split-field view on the screen 75 of the first TV monitor 52, the substage 38 may be adjusted and the X and Y servo drive units 34 and 35 may be employed to move the main stage 30 as required to precisely position the reference mark 32 in and parallel to the image plane of the projection lens 26 and to align the reference mark with respect to the orthogonal X and Y axes of motion of the system 10 in the same manner as fully described in European Patent Application No. 81 100 559.4. Following this reference mark set-up alignment operation, the reference mark 32 may be employed for aligning the images of the global alignment marks 42a and 42b of every main reticle 12 employed in the system 10 with respect to the orthogonal axes of motion of the system. This can also be accomplished, while observing the split-field view on the screen 75 of the first TV monitor 52 and in the same manner as fully described in European Patent Application No. 81 100 559.4, by employing the X and differential Y servo drive units 20, 22a and 22b to align the projected images of the global alignment marks 42a and 42b of each main reticle 12 with respect to the corresponding double-cross alignment marks 39 and 40 of the reference mark 32 precisely as shown in Figure 5.

As shown in Figure 3, each first-level main reticle 12 also contains another pair of global alignment marks 76a and 76b and a local alignment mark 78 to be photometrically printed onto each semiconductive wafer 14 processed with that first-level main reticle. On each such first-level main reticle 12, the global alignment marks 76a and 76b are disposed in marginal areas adjacent to opposite sides of the main reticle and spaced the same finite center-to-center distance D/2 (for example, 500 microns) above the centerline 43 of the main reticle as the global alignment marks 42a and 42b are spaced below that centerline. The local alignment mark 78 is disposed in a marginal area of each first-level main reticle 12 between the global alignment marks 76a and 76b and may, for example, also be spaced the same finite center-to-center distance D/2 above the centerline 43 of the main reticle. The global alignment marks 76a and 76b may be photometrically printed in marginal areas of the semiconductive wafer 14, as shown in Figures 6 and 7, in the same manner as fully described in European Patent Application No. 81 100 559.4.

The local alignment mark 78 of the first-level main reticle 12 may be photometrically printed onto the semiconductor wafer 14 together with the first level of microcircuitry contained on the first-level main reticle in a step-and-repeat manner as shown in Figures 6 and 7 and as fully explained in European Patent Application No. 81 100 559.4. This may be done either during the course of or immediately following the printing of the global alignment marks 76a and 76b onto the semiconductive wafer 14 and normally does not require any wafer alignment operation since no other level of microcircuitry has yet been photometrically printed onto or formed in the semiconductive wafer. If, as shown in Figures 3, 4A and 4B, the first-level and higher-level main reticles 12 contain four separate rectangular areas 80 of microcircuitry, the local alignment mark 78 of the first-level main reticle 12 will be repetitively photometrically printed onto the semiconductive wafer 14 in a central marginal area between four corresponding inchoate dice regions 82 of the semiconductive wafer, as shown in Figures 6 and 7. However, if the first-level and higher-level main reticles 12

-20-

contained a single larger rectangular area of microcircuitry, rather than four separate rectangular areas 80, the local alignment mark 78 of the first-level main reticle 12 could be relocated, for example, along a centerline 84 of the first-level main reticle 12 to a marginal area at one side of the first-level main reticle to avoid interference with the microcircuitry. Although the global alignment marks 76a and 76b and the local alignment mark 78 contained on the first-level main reticle 12 may, as shown, all comprise double-cross alignment marks of the same type as the alignment marks 39, 40 and 41 of the reference mark 32, different types of alignment marks could be used.

Following the photometric printing operations involving the first-level main reticle 12, a second-level main reticle 12, such as that shown in Figure 4A or 4B is positioned on the reticle stage 16 in place of the first-level main reticle. Images of the global wafer alignment marks 42a and 42b of the second-level main reticle 12 are aligned as described above with respect to the corresponding double-cross alignment marks 39 and 40 of the reference mark 32 to align the second-level main reticle with respect to the orthogonal X and Y axes of motion of the system 10. The X and Y axes servo drive units 34 and 35 are then employed for moving the main stage 30 to position the double-cross alignment mark 39 of the reference mark 32 at a coordinate position directly beneath the projection lens 26 where that double-cross alignment mark is illuminated by a projected image of a local alignment mark 88 contained on each second and higher level main reticle 12. The objective optical system 46 also includes a single-channel objective lens unit 89 that can be employed for directly viewing an aerial image of the double-cross alignment mark 39 of the reference mark 32 as illuminated by the image of the local alignment mark 88 contained on any second and higher level main reticle 12.

As best shown in Figures 4A and 4B, the local alignment mark 88 is disposed on each second and higher level main reticle 12 in a marginal area between the global alignment marks 42a and 42b and is spaced below the centerline 43 of each such main reticle by the same finite center-to-center distance D/2 (for example, 500 microns) as the global alignment marks 42a and 42b. However, the local alignment mark 88 could be relocated, for example, along the centerline 84 of each such main reticle 12 to a marginal area at one side of the main reticle to avoid interference with any different configuration of microcircuitry as mentioned above. Although the local alignment mark 88 of each such main reticle 12 may, as shown, be of the same type as the global alignment marks 42a and 42b of each such main reticle, different types of alignment marks could be used.

A second or higher level main reticle 12 of the type shown in Figure 4A, is employed when processing a semiconductive wafer 14 coated with a positive photoresist. However, if a main reticle 12, such as that shown in Figure 4A, were employed when processing a semiconductive wafer 14 coated with a negative photoresist, the global and local double-cross alignment marks 76a, 76b and 78 of the semiconductive wafer 14 could be obliterated during subsequent processing. This problem can be eliminated by employing a second or higher level main reticle 12 of the type shown in Figure 4B when processing a semiconductive wafer 14 coated with negative photoresist. A separate transparent rectangular window 90 is included on each such main reticle 12 adjacent to each of the global alignment marks 42a, 42b and 88 and spaced the same finite center-to-center distance D/2 above the centerline 43 as the double-cross alignment marks 76a, 76b and 78 are spaced above the centerline 43 of each first-level main reticle 12. Thus, each such transparent rectangular window 90 of a second and higher level main reticle 12 of the type shown in Figure 4B serves to expose the negative photoresist overlying the corresponding double-cross alignment mark 76a, 76b or 78 of the semiconductive wafer 14 and thereby prevent subsequent processing from obliterating that double-cross alignment mark.

The single-channel objective lens unit 89 includes a cold mirror 92 disposed along a first horizontally-extending portion of an optical path 94 of the system 10 and serving as a chromatic beam splitter for deflecting the blue exposure light and transmitting the yellow nonexposure light. Cold mirror 92 therefore deflects the blue exposure light, which is reflected forwardly along the first horizontally-extending portion of the optical path 94 by the nonchromatic beam splitter 44, downwardly along a first vertically-extending portion of the optical path 94 through an infinity-corrected objective lens 96 and an associated imaging lens 98 to a beam bender 100. The cold mirror 92, the infinity-corrected objective lens 96, the imaging lens 98, and the beam bender 100 serve as a pivotally and

longitudinally adjustable periscope in the same manner as fully described in European Patent Application No. 80 101 307.9.

Beam bender 100 is disposed for deflecting the reflected blue exposure light forwardly along a second horizontally-extending portion of the optical path 94 to another beam bender 102, from which the reflected blue exposure light is in turn deflected downwardly along a second vertically-extending portion of optical path 94. An actuator 104, such as an air cylinder, is employed for moving the split-field prism 74 out of the dual-channel optical path 60a and 60b and moving a blocking plate 106 into that optical path. The blue exposure light deflected downwardly along the second vertically-extending portion of the optical path 94 thereby impinges upon the input face of the first TV camera tube 48. A view of the aerial image of the double-cross alignment mark 39 of the reference mark 32 as illuminated by the projected image of the local alignment mark 88 of the second-level main reticle 12 is thereby produced on the screen 75 of the first TV monitor 52, as shown in Figure 8A or 8B, depending on whether a second-level main reticle for positive photoresists or negative photoresists is being employed. While observing the view of this aerial image provided by the first TV monitor 52, the X and Y axes servo drive units 34 and 35 may be employed for moving the main stage 30 to precisely align the double-cross alignment mark 39 of the reference mark 32 with respect to the image of the illuminated corresponding local alignment mark 88 of the second-level main reticle 12.

Referring again to Figure 1, the system 10 includes

-24-

a first nonexposure light source 108 for illuminating the adjustable alignment reticle 28 with the yellow nonexposure light when a shutter 110 associated with that light source is opened, as shown in dashed lines. The system 10 also includes an X-axis servo drive unit 112 and a Y-axis servo drive unit 114 coupled to the alignment reticle 28 and employed for moving the alignment reticle along the orthogonal X and Y axes of the system to align an image of an illuminated alignment mark 116 of the alignment reticle with respect to the double-cross alignment mark 41 of the reference mark 32. Accordingly, the objective optical system 46 includes a single-channel objective lens unit 118 disposed along another optical path 120 of the system 10 with the first nonexposure light source 108 and the alignment reticle 28 to image the illuminated alignment mark 116 of the alignment reticle at the image plane of the projection lens 26 and also to directly view an aerial image of the double-cross alignment mark 41 of the reference mark 32 as illuminated by the image of the illuminated alignment mark of the alignment reticle. The illuminated alignment mark 116 of the alignment reticle 28 may, as shown, be of the same type as the global alignment marks 42a and 42b of each main reticle 12.

The single-channel objective lens unit 118 includes a beam bender 122 disposed for deflecting yellow exposure light, which is directed upwardly along a first vertically-extending portion of optical path 120 through the alignment mark 116 of the alignment reticle 28, forward along a first horizontally-extending portion of the optical path 120 to another beam bender 124. Beam bender 124 is disposed for in turn deflecting that yellow exposure light upwardly along a second vertically-extending portion of optical path 120 and through a first nonchromatic beam splitter 126, a second nonchromatic beam splitter 128, an imaging lens 130, and an infinity-corrected objective lens 132 to another beam bender 134. These beam benders 124 and 134, beam splitters 126 and 128, and lenses 130 and 132 serve as another pivotally and longitudinally adjustable periscope in the same manner as fully described in European Patent Application No. 80 101 307.9. The beam bender 134 is disposed for deflecting the incident yellow exposure light along a second horizontally-extending portion of the optical path 120 and through the cold mirror 92 to the nonchromatic beam splitter 44, from whence that yellow nonexposure light is reflected downwardly through the projection lens 26 onto the double-cross alignment mark 41 of the reference mark 32 in the image plane of the projection lens. It should be noted that the apparently common horizontally-extending and vertically-extending portions of the optical path 94 for blue exposure light, of the optical path 120 for yellow nonexposure light, and of the optical path 18 for both types of light are actually spaced about 100 microns apart between the projection lens 26 and the cold mirror 92.

Yellow nonexposure light is reflected upwardly back along the optical path 18 from the illuminated double-cross alignment mark 41 of the reference mark 32 disposed in the image plane of the projection lens. This reflected yellow exposure light passes back through the projection lens 26 to the nonchromatic beam splitter 44, from which it is reflected back along the optical path 120 through the cold

-26-

mirror 92, the infinity-corrected objective lens 132 and the imaging lens 130 to the nonchromatic beam splitter 128. This nonchromatic beam splitter 128 is disposed for deflecting the incident reflected yellow nonexposure light along a third horiaontally-extending portion of the optical path 120 to a beam bender 136, from which it is reflected downwardly along a third vertically-extending portion of that optical path to another beam bender 138. Beam bender 138 is disposed for deflecting the incident yellow nonexposure light along a fourth horizontally-extending portion of optical path 120 to another beam bender 140, which is in turn disposed for deflecting that yellow nonexposure light downwardly along a fourth vertically-extending portion of that optical path to the input face of the second TV camera tube 50.

A view of the aerial image of the double-cross alignment mark 41 of the reference mark 32 as illuminated by the projected image of the illuminated global alignment mark 116 of the alignment reticle 28 is accordingly produced on the screen 142 of the second TV monitor 54 coupled to the second TV camera tube 50. While observing this view of the aerial image provided by the second TV monitor 54, the X and Y axes servo drive units 112 and 114 may be employed for moving the alignment reticle 28 to precisely align the image of the alignment mark 116 of the alignment reticle with respect to the illuminated double-cross alignment mark 41 of the reference mark 32, as shown in Figure 9. Since the corresponding double-cross alignment mark 39 of the reference mark 32 has concomitantly been aligned with respect to the image of the local alignment

-27-

mark 88 of the second-level main reticle 12, and since images of the global alignment marks 42a and 42b of the second-level main reticle 12 have previously been aligned with respect to the orthogonal X and Y axes of motion of the system 10, it may be seen that the image of the alignment mark 116 of the alignment reticle has been bore-sighted into alignment with respect to the orthogonal X and Y axes of motion of the system.

Following the foregoing alignment reticle set-up alignment operation, which may be repeated as often as desired to maintain the alignment accuracy of the system 10, both the global and local double-cross alignment marks 76a, 76b and 78 printed on the semiconductive wafer 14 can be precisely aligned with respect to the image of the alignment mark 116 of the alignment reticle 28. This may be done by employing the X and Y axes servo drive units 34 and 35 for moving the main stage 30 to a position directly beneath the projection lens 26 at which the desired double-cross global or local alignment mark 76a, 76b or 78 of the semiconductive wafer 14 is illuminated by the image of the alignment mark 116 of the alignment reticle 28. Then, while observing the view of the aerial image of that double-cross global or local alignment mark 76a, 76b or 78 as illuminated by the image of the alignment mark 116 and as provided on the screen 142 of the TV monitor 54, the X, Y and Z axes servo drive units 34, 35 and 37 are employed as necessary for positioning the semiconductive wafer 14 to align that double-cross alignment mark with respect to that image, as shown in Figure 10. This operation may be performed in the same way when processing the semiconductive wafer 14 with any second or higher level main reticle 12.

The objective optical system 46 also includes an apertured plate 144 disposed along another optical path 146 of the system 10 at the image plane of imaging lens 130 to provide a field stop 148. A second nonexposure light source 150 is also disposed along this optical path 146 and, when an associated shutter 151 is opened (as shown in solid lines), is employed with a beam bender 152 to uniformily illuminate the field stop 148 with yellow nonexposure light having a wavelength of 577 nanometers. When shutter 151 is opened shutter 110 is normally closed. The yellow nonexposure light passing through the field stop 148 is deflected to the imaging lens 130 via beam benders 154 and 156 and by nonchromatic beam splitters 126 and 128 and is imaged at the image plane of the projection lens 26 by the imaging lens 130, the infinity-corrected lens 132, and the projection lens 26 so as to illuminate the entire field viewed in that image plane by the single-channel objective lens unit 118. This is especially helpful in locating the global alignment marks 76a and 76b on the semiconductive wafer 14 during the global alignment operation.

Referring now to Figures 11A and 11B, there is shown another precision step-and-repeat alignment and exposure system 160, according to another of the preferred embodiments of this invention, for repeatedly photometrically printing a level of microcircuitry contained on a first object, such as a main reticle 12, at an array of adjacent regions of a second object, such as a semiconductive wafer 14, in alignment with other levels of microcircuitry preciously printed or yet to be printed at each of those same regions. In describing the system of Figures 11A and 11B, the same reference numerals are employed for many parts that are identical or similar to those of the system 10 of Figure 1 so that Figures 2 through 10 can also be employed in describing the operation of the system 160 of Figures 11A and 11B.

The system 160 includes a reticle stage 16, which is employed for holding the main reticle 12 along a horizonally-extending portion of an optical path 162 of the system, which is provided with a clearance opening for permitting passage of light through the main reticle, and which may be moved along orthogonal X and Y axes and rotated about an orthogonal Z axis of the reticle stage by an X-axis servo drive unit 20 and a pair of differential Y-axis servo drive units 22a and 22b coupled to the reticle stage. A main stage 30 is employed for holding the semiconductive wafer 14 and a reference mark 32 and for selectively positioning them along a vertically-extending portion of the optical path 162. The main stage 30 may be moved along orthogonal X and Y axes of the main stage by an X-axis servo drive unit 34 and a Y-axis servo drive unit 35 coupled to the main stage. A rotatable vacuum chuck 36, which is mounted on the main stage 30 and which may be rotated about an axis parallel to a Z axis of the main stage 24 by a θ servo drive unit 37 coupled to the vacuum chuck, is employed for holding the semiconductive wafer 14 on the main stage.

A source 164 of blue exposure light having a wavelength of about 436 nanometers is employed both for illuminating the main reticle 12 and for exposing a photo-resistive film on the semiconductive wafer 14. The exposure light is directed along a first vertically-extending portion of an optical path 166 to a beam splitter 168, which is disposed so as to reflect eighty percent of the incident exposure light from that portion of that optical path along the horizontally-extending portion of the optical path 162 towards the main reticle 12. First and second sources 108 and 150 of yellow exposure light having a wavelength of about 577 nanometers are employed for illuminating an adjustable alignment reticle 28 and an apertured field-stop plate 144, respectively, without exposing the photo-resistive film on the semiconductive wafer 14. The nonexposure light is directed along an optical path 170 to a plane mirror 172, which is disposed so as to reflect the incident nonexposure light along a first vertically-extending portion of that optical path and into the vertically-extending portion of the optical path 162 towards the semiconductive wafer 14 (the first vertically-extending portion of the optical path 170 adjoins the vertically-extending portion of the optical path 162).

A cold mirror 174 is disposed between the reticle stage 16 and the main stage 30 and employed for bidirectionally reflecting exposure light from one portion of the optical path 162 to the other portion of the same optical path and for bidirectionally transmitting nonexposure light between the adjoining vertically-extending portions of the optical paths 162 and 170. The cold mirror 174 is bonded to a glass substrate 176 with a circular clearance opening 178 permitting nonexposure light to pass directly through the cold mirror between the adjoining vertically-extending portions of the optical paths 162 and 170 (i.e., without traversing the glass substrate). A 10:1 reduction-type projection lens 26 is disposed along the vertically-extending portion of the optical path 162 between the cold mirror 174 and the main stage 30 and employed for projecting an image of the illuminated main reticle 12 into an image plane of the projection lens during alignment and exposure operations as hereinafter described. The projection lens 26 is also employed for projecting an image of either the illuminated alignment reticle 28 or the illuminated apertured field-stop plate 144 into the same image plane during alignment operations as hereinafter described. In any case, the main stage 30 is employed for positioning the semiconductive wafer 14 of the reference mark 32 in the image plane of the projection lens 26 along the vertically-extending portion of the optical path 162 and with respect to the projected image of the illuminated main reticle 12 or of the illuminated alignment reticle 28.

With reference now primarily to Figure 11B, the source 164 of exposure light includes a mercury arc lamp 180 for emitting a spectrum of light energy including the blue exposure light. An elliptical reflector 182 surrounds the mercury arc lamp 180 and is coaxially mounted therewith for projecting a beam of light emitted by the mercury arc lamp downward along a second vertically-extending portion of optical path 166 to a band reflecting plane mirror 184. The band reflecting plane mirror 184 has a multilayer dielectric coating for reflecting the blue exposure light, but transmitting all other light, and is disposed so as to reflect only the blue exposure light in the beam of light from mercury arc lamp 180 along a horizontally-extending portion of optical path 166 to a plane mirror 186. Concomitantly, the plane mirror 186 is disposed so as to reflect the blue exposure light incident thereon upward along the first vertically-extending portion of optical path 166 through a light integrator 188 disposed in that portion of that optical path towards the beam splitter 168.

The light integrator 188 is employed for providing the beam of blue exposure light passing therethrough with a cross section corresponding to the entrance pupil of the projection lens 26 and with a uniform intensity distribution in the plane of the main reticle 12. A shutter 190 is pivotally mounted adjacent to the first vertically-extending portion of optical path 166 between the light integrator 188 and the beam splitter 168 and is controlled by a θ servo drive unit 192 for pivotal movement into that optical path when closed (as shown in solid lines) and out of that optical path when opened (as shown in dashed lines). The shutter 190 has a circular ($ND_3$) neutral density filter 194 mounted therein and operable, when the shutter is closed, for passing only about one-thousandth of the blue exposure light from the light integrator 188 to the beam splitter 168 so as to illuminate the main reticle 12 with sufficient intensity to be picked up by a silicon intensified TV camera as hereinafter described, but with insufficient intensity to expose the photoresistive film on the semiconductive wafer 14. When the shutter 190 is opened, all of the blue exposure light from the light integrator 188 passes to the beam splitter 168 so as to illuminate the main reticle 12 and to expose the photoresistive film on the semiconductive wafer 14 in accordance with the pattern of the illuminated main reticle.

Two positive lenses 196 and 198 are also disposed in the first vertically-extending portion of optical path 166 between the source 164 of blue exposure light and the nonchromatic beam splitter 168 to image the output of the light integrator 188 at the input pupil of an imaging lens 200 disposed in the horizontally-extending portion of optical path 162 between the beam splitter and the reticle stage 16. A slide 202 is mounted for movement along a Y axis of the slide under control of a Y-axis servo drive unit 204 to selectively position either of two different mask plates 206 and 208 at an operative position directly between positive lenses 196 and 198 in a horizontal plane orthogonally intersecting the first vertically-extending portion of optical path 166 at a point midway between those positive lenses.

As shown in Figures 11A and 11B, the blue exposure light appearing in the horizontal plane midway between the positive lenses 196 and 198 is imaged by the imaging lens 200 onto selected portions or all of the main reticle 12 during alignment and exposure operations as hereinafter described and as determined by whether or not one of the mask plates 206 and 208 is located in the operative position (and, if so, which one). Another positive lens 210 is disposed in the horizontally-extending portion of the optical path 162 between the imaging lens 200 and the reticle stage 16 so as to image the blue exposure light, which appears at the output pupil of the imaging lens (and which passes through the main reticle 12 and is reflected by the cold mirror 174), at the input pupil of the projection lens 26. The blue exposure light so imaged is projected downwardly along the vertically-extending portion of the optical path 162 by the projection lens 26 to provide an image of the illuminated portions of the main reticle 12 in the image plane of the projection lens as previously mentioned.

The blue exposure light projected into the image plane of the projection lens 56 is reflected from the semiconductive wafer 14 or the reference mark 32, depending upon which one is positioned in that image plane and in the vertically-extending portion of the optical path 162. This reflected blue exposure light passes upwardly along the vertically-extending portion of the optical path 162 through the projection lens 26 to the cold mirror 174, from which the reflected blue exposure light is in turn reflected along the horizontally-extending portion of the optical path 162 through the main reticle 12. The positive lens 210 serves to image the reflected blue exposure light emanating from the input pupil of the projection lens 26 at the output pupil of the imaging lens 200. Twenty percent of the reflected blue exposure light so imaged is transmitted by the beam splitter 168 to a positive lens 212 disposed in the horizontally-extending portion of the optical path 162.

The imaging lens 200 serves to image the reflected blue exposure light, which appears at the main reticle 12 and is transmitted by the beam splitter 168, at the object plane of a split-field objective lens unit 214 (with that object plane being optically the same distance from the

-35-

input pupil of the imaging lens as the horizontal plane midway between the positive lenses 196 and 198 is from the input pupil of the imaging lens). Concomitantly, the positive lens 212 serves to image the reflected blue exposure light, which emanates from the input pupil of the imaging lens 200, at infinity so that the reflected blue exposure light is telecentrically imaged at the object plane of the split-field objective lens unit 214. This provides in that object plane an image of both the aforementioned image of the illuminated portions of the main reticle and of those portions of the semiconductive wafer 14 or the reference mark 32 illuminated by the aforementioned image of the illuminated portions of the main reticle.

The split-field objective lens unit 214 may comprise, for example, a Zeiss MJM mask alignment microscope with a pair of objective lenses 216a and 216b. These objective lenses 216a and 216b are mounted on corresponding manually-rotatable turrets 218a and 218b, which are in turn mounted on corresponding manually-translatable slides 220a and 220b. The turrets 218a and 218b and the slides 220a and 220b are disposed so that the objective lenses 216a and 216b can be manually rotated or manually moved laterally (along an X axis of the split-field objective lens unit 214) relative to one another as may be desired to permit viewing of different portions of the image at the object plane of the split-field objective lens unit or to permit either split-field (dual channel) or single field (single channel) viewing of that image. A Y-axis servo drive unit 222 is

-36-

coupled to the split-field objective lens unit 214 to facilitate vertical adjustment of the objective lenses 216a and 216b (along a Y axis of the split-field objective lens unit).

Depending on the position of the objective lenses 216a and 216b, a dual channel or a single channel view of the image appearing in the object plane of the split-field objective lens unit 214 is provided at an optical output port of the split-field objective lens unit. A silicon intensified TV camera 224 is coupled to the output port of the split-field objective lens unit 214 and to a first TV monitor 226 so as to display the dual channel or single channel view of that image on the display screen 228 of the first TV monitor. While viewing the display screen 228 of the first TV monitor 226, an operator may control the main stage 30 to position the semiconductive wafer 14 or the reference mark 32 and may also control the reticle stage 16 to position the main reticle 12 in performing the alignment operations as hereinafter described.

As previously disclosed in European Patent Applications Nos. 80 101 307.9 and 81 100 559.4, as well as in connection with the system 10 of Figure 1 of this patent application, the reference mark 32 may be formed of bright chrome on a substage 38 of the main stage 30, the substage may be employed during a reference mark set-up alignment operation to precisely position the reference mark in and parallel to the image plane of the projection lens 26 and to precisely align the reference mark with respect to the orthogonal X and Y axes of motion of the main stage. Once the reference mark 32 is so aligned it serves as a visual indication of the orthogonal X and Y axes of motion of the main stage 30 and thereby facilitates use of those axes of motion as an absolute frame of reference for the system 160.

As previously described in connection with the system 10 of Figure 1 of this patent application, the reference mark 32 includes a left-hand double-cross alignment mark 40 and two right-hand double-cross alignment marks 39 and 41, as shown in Figure 2, every first-level main reticle 12 includes a pair of global alignment marks 42a and 42b (for use in aligning an image of the main reticle) and a pair of global alignment marks 76a and 76b and a local alignment mark 78 (to be photometrically printed onto the semiconductive wafer 14 for use in aligning the semiconductive wafer), as shown in Figure 3, and every second and higher level main reticle 12 includes a pair of global alignment marks 42a and 42b (for use in aligning an image of the main reticle) and a local alignment mark 88 (for use in boresighting alignment of the alignment reticle 28), as shown in Figures 4A and 4B. Every first-level main reticle may include more than one local alignment mark 78 (a separate local alignment mark 78 is required for each second and higher level main reticle when performing alignment operations with blue exposure light, whereas a single local alignment mark 78 is sufficient when performing alignment operations with yellow nonexposure light). In the case of a second-level or higher-level main reticle 12, which is to be used in performing alignment operations with blue exposure light, the local alignment mark 88 is located at a position determined by the corresponding local alignment mark 78 on the associated first-level main reticle, as described in European Patent Application No. 81 100 559.4. Every second and higher level main reticle 12 to be employed when processing a semiconductive wafer coated with negative photoresist may also include a separate transparent rectangular window 90 adjacent to each of the global and local alignment marks 42a, 42b and 88, as further shown in Figure 4B, for reasons previously described in connection with the system 10 of Figure 1.

During each step-and-repeat printing operation, images of the global alignment marks 42a and 42b on the main reticle 12 are first aligned with respect to the corresponding right-hand and left-hand double-cross alignment marks 39 and 40 of the reference mark 32 to precisely align the main reticle with respect to the orthogonal X and Y axes of motion of the main stage 30. This main reticle alignment operation may be performed in generally the same manner as described in European Patent Application No. 80 101 307.9 by moving the shutter 190 to the closed position; by moving the main stage 30 to a position at which the reference mark 32 is centered directly beneath the projection lens 26; by moving the slide 202 to position the mask plate 208 at the operative position between the positive lenses 196 and 198 so that the global alignment marks 42a and 42b of the main reticle 12 are illuminated by blue exposure light, which passes through corresponding circular openings 230a and 230b in that mask plate and is imaged at those global alignment marks by the imaging lens 200, and so that the corresponding double-cross alignment marks 39 and 40 of the reference mark are illuminated by images of those illuminated global alignment marks; and by moving the reticle stage 16, while employing both objective lenses 216a and 216b of the split-field objective lens unit 214 and viewing the display screen 228 of the TV monitor 226, to align the images of the illuminated global alignment marks 42a and 42b of the main reticle with the illuminated double-cross alignment marks 39 and 40 of the reference mark, as shown in Figure 5. In the case of each first-level main reticle 12 the global and local alignment marks 76a, 76b and 78 are thereupon photometrically printed on the semiconductive wafer 14 along with the first level of microcircuitry contained on the first level main reticle, as previously described in connection with the system 10 of Figure 1.

Following the main reticle alignment and photometric printing operations involving the first-level main reticle 12, and following the main reticle alignment operation involving each second-level and higher-level main reticle (all of which operations are performed as described above by employing the blue exposure light), the global alignment marks 76a and 76b printed at opposite sides of the semiconductive wafer 14 are each aligned with respect to an image of one of the global alignment marks 42a and 42b or with respect to an image of the local alignment mark 88 disposed on each second-level and higher-level main reticle to align the semiconductive wafer as a whole with respect to the orthogonal X and Y axes of the main stage 30. This global wafer alignment operation may be performed in generally the same manner as described in European Patent Application No. 80 101 307.9 in connection with the initial or set-up semiconductive wafer by retaining the shutter 190 in or moving it to the closed position; by moving the main stage 30 to a position at which a global alignment mark 76a or 76b of the semiconductive wafer 14 is nominally aligned, for example, with respect to an image of the local alignment mark 88 of the main reticle 12; by moving the slide 202 to position the mask plate 206 at the operative position between the positive lenses 196 and 198 so that the local alignment mark 88 of the main reticle is illuminated by blue exposure light, which passes through a rectangular opening 232 in that mask plate and is imaged at a central region of the main reticle (the central region including all of the areas of microcircuitry 80 and the local alignment mark 88, but not the global alignment marks 42a and 42b) by the imaging lens 200, and so that the global alignment mark 76a or 76b of the semiconductive wafer is illuminated by the image of the illuminated local alignment mark 88 of the main reticle; by moving the main stage 30, while employing either one of the objective lenses 216a and 216b of the split-field objective lens unit 214 and viewing the display screen 228 of the TV monitor 226, to align the global alignment mark 76a or 76b of the semiconductive wafer with respect to the image of the local alignment mark 88 of the main reticle as shown in Figures 8A and 8B; by repeating those of the foregoing steps necessary to align the other global alignment mark 76a and 76b of the semiconductive wafer with respect to the image of the same local alignment mark 88 of the main reticle; and by thereupon rotating the vacuum chuck 36 to position the aligned global alignment marks 76a and 76b at the same coordinate of the Y axis of the main stage.

Following the global wafer alignment operation the areas 80 of microcircuitry contained on the second-level or higher-level main reticle 12 may be photometrically printed onto the semiconductive wafer 14 in a step-and-repeat exposure operation in the same manner as described in European Patent Application No. 80 101 307.9. This is accomplished by moving the mask plate 206 to or retaining it in the operative position between positive lenses 196 and 198; by stepping the main stage 30 to different positions so as to successively locate different areas of the semiconductive wafer at a centered position directly beneath the projection lens 26; and by momentarily moving the shutter 190 to the open position at each such position of the main stage to expose the photoresistive film on the semiconductive wafer at each such area of the semiconductive wafer in accordance with the main reticle.

In the process of performing the foregoing step-and-repeat exposure operation, the local alignment mark 78 printed on the semiconductive wafer 14 in the central marginal area between each group of four inchoate dice regions 82 may also be aligned with respect to an image of the local alignment mark 88 of the second-level or higher-level main reticle 12 to more precisely align each of those inchoate dice regions with respect to an image of the main reticle before exposing the photoresistive film at those inchoate dice regions. This precision region-by-region or local wafer alignment operation may be performed in the same manner as described above in connection with the alignment of one of the global alignment marks 76a or 76b of the semiconductive wafer 14 and as described in European Patent Application No. 80 101 307.9.

The system 160 includes an objective optical unit 234 for use in performing the aforementioned wafer alignment operations with the yellow nonexposure light if, for example, those alignment operations cannot be performed with the blue exposure light because the photoresistive film on the semiconductive wafer 14 is opaque to the blue exposure light. In order to provide the objective optical unit 234 with a secondary alignment standard with respect to which the semiconductive wafer 14 may be aligned to perform those wafer alignment operations, the right-hand double-cross alignment mark 39 of the reference mark 32 is precisely aligned with respect to the image of the local alignment mark 88 of the main reticle 12. This is accomplished by moving the main stage 30 to a position at which the double-cross alignment mark 39 of the reference mark 32 is nominally aligned with respect to an image of the local alignment mark 88 of the main reticle 12, which has previously been precisely aligned with respect to the orthogonal X and Y axes of motion of the main stage 30 as described above; by moving the mask plate 206 to or retaining it in the operative position between the positive lenses 196 and 198 so as to illuminate the local alignment mark 88 of the main reticle and, hence, the double-cross alignment mark 39 of the reference mark; by moving the shutter 190 to or retaining it in the closed position; and by moving the main stage 30, while employing either one of the objective lenses 216a and 216b of the split-field objective lens unit 214 and viewing the display screen 228 of the TV monitor 226, to precisely align the illuminated double-cross alignment mark 39 with respect to the image of the illuminated local alignment mark 88 of the previously-aligned main reticle 12.

Concomitantly, an image of an alignment mark 116 of the alignment reticle 28 (which is illuminated by the source 108 of yellow nonexposure light when a shutter 110 associated with that light source is opened, as shown in solid lines)., is precisely aligned with respect to the double-cross alignment mark 41 of the reference mark 32 in a bore-sighting alignment operation as hereinafter described.  This bore-sighting alignment operation is performed by employing the objective optical unit 234, together with the plane mirror 172, an astigmatism corrector 234, the cold mirror 174 and the projection lens 26, to project an image of the illuminated alignment mark 116 of the alignment reticle 28 into the image plane of the projection lens.  The astigmatism corrector 234 is disposed in the first vertically-extending portion of the optical path 170 between the cold mirror 174 and the plane mirror 172 (but may be disposed anywhere in that optical path between the cold mirror and an objective lens 236 of the objective optical unit 234) to compensate for astigmatism produced by the cold mirror.

The source 108 of yellow nonexposure light and the alignment reticle 28 are disposed in a second vertically-extending portion of the optical path 170 with the shutter 110 pivotally disposed for blocking the passage of yellow nonexposure light from that light source to the alignment reticle when the shutter is closed, as shown in dashed lines, under control of a θ servo drive unit (not shown).
An X-axis servo drive unit 112 and a Y-axis servo drive
unit 114 are coupled to the alignment reticle 28 and employed
for moving the alignment reticle along orthogonal X and Y
axes of the alignment reticle to align the image of the
illuminated alignment mark 116 of the alignment reticle
with respect to the double-cross alignment mark 41
of the reference mark 32. A beam bender 238 is disposed
for deflecting yellow nonexposure light, which is directed
upwardly along the second vertically-extending portion of
optical path 170 through the alignment mark 116 of
the alignment reticle 28, forward along a horizontally-
extending portion of that optical path through beam
splitters 240 and 242 to the objective lens 236. The
objective lens 236 is disposed along the horizontally-
extending portion of the optical path 170 so as to image
the illuminated alignment mark 116 of the alignment
reticle 28 at the image plane of the projection lens 26
and also to directly view an aerial image 244 of the
double-cross alignment mark 41 of the reference mark 32
as illuminated by the image of the illuminated alignment
mark of the alignment reticle. The illuminated alignment
mark 116 of the alignment reticle 28 may, as shown, be
of the same type as the global and local alignment marks
42a, 42b and 88 of each main reticle 12.

Yellow nonexposure light is reflected upwardly back
along the vertically-extending portion of the optical
path 162 from the illuminated double-cross alignment
mark 41 of the reference mark 32 disposed in the image
plane of the projection lens. This reflected yellow

-45-

exposure light passes back through the projection lens 26, the cold mirror 174 and the astigmatism corrector 234 to the plane mirror 172, from which it is reflected to form the aerial image 244 of the double-cross alignment mark 41 of reference mark 32 (as illuminated by the image of the illuminated alignment mark 116 of the alignment reticle 28). The objective lens 236 reimages this aerial image 244 via the beam splitter 242 along a third vertically-extending portion of the optical path 170 at the input face of a TV camera 246. A view of this aerial image 244 is accordingly produced on the display screen 248 of a second TV monitor 250, which is coupled to the TV camera 246. While observing this view of the aerial image 244 provided by the second TV monitor 250, the X- and Y-axes servo drive units 112 and 114 may be employed for moving the alignment reticle 28 to precisely align the image of the alignment mark 116 of the alignment reticle with respect to the illuminated double-cross alignment mark 41 of the reference mark 32, as shown in Figure 9. Since the corresponding double-cross alignment mark 39 of the reference mark 32 has concomitantly been aligned with respect to the image of the local alignment mark 88 of the second-level or higher-level main reticle 12, and since images of the global alignment marks 42a and 42b of that main reticle have previously been aligned with respect to the orthogonal X and Y axes of motion of the main stage 30, it may be seen that the image of the alignment mark 116 of the alignment reticle 28 has been bore-sighted into alignment with respect to the orthogonal X and Y axes of motion of the main stage.

Following the foregoing bore-sighting alignment reticle set-up alignment operation, which may be repeated as often as desired to maintain the alignment accuracy of the system 160, both the global and local double-cross alignment marks 76a, 76b and 78 of the semiconductive wafer 14 can be precisely aligned with respect to the image of the illuminated alignment mark 116 of the alignment reticle 28 while employing the yellow nonexposure light. This may be done by employing the X- and Y-axes servo drive units 112 and 114 for moving the main stage 30 to a position at which the desired double-cross global or local alignment mark 76a, 76b or 78 of the semiconductive wafer 14 is centered directly beneath the projection lens 26 and illuminated by the image of the illuminated alignment mark 116 of the alignment reticle 28. Then, while observing the view of the aerial image 244 of that double-cross global or local alignment mark 76a, 76b or 78, as illuminated by the image of the illuminated alignment mark 116 of the alignment reticle 28 and as provided on the screen 248 of the TV monitor 250, the X-, Y- and θ-axes servo drive units 34, 35 and 37 are employed as necessary for moving the main stage 30 and rotating the vacuum chuck 36 to align that illuminated double-cross alignment mark of the semiconductive wafer with respect to the image of the illuminated alignment mark of the alignment reticle, as shown in Figure 10. This operation may be performed in the same way when processing the semiconductive wafer 14 with any second-level or higher-level main reticle 12.

The objective optical unit 234 also includes the apertured field-stop plate 144, which is disposed along a

-47-

fourth vertically-extending portion of the optical path 170 at the image plane of the objective lens 236 to provide a field stop 252. The second source 150 of nonexposure light is also disposed along the fourth vertically-extending portion of the optical path 170 so as to uniformly illuminate the field stop 252 with yellow nonexposure light when an associated shutter 151 is opened, as shown in dashed lines. When the shutter 151 is opened, the shutter 110 is normally closed. The yellow nonexposure light passing through the field stop 252 is reflected to the objective lens 236 via the beam splitter 240 and is imaged at the image plane of the projection lens 26 by that objective lens and the projection lens 26 so as to illuminate the entire field viewed in that image plane by the objective lens unit 234. This is especially helpful in locating the global alignment marks 76a and 76b on the semiconductive wafer 14 during the global alignment operation.

Claims

1. A step-and-repeat alignment and exposure
system (10 or 160) for aligning first and second objects
(12 & 14), said system including first means (16) for
holding the first object (12); second means (30) for
holding the second object (14); a first reference indicium
(32) disposed on the second means (30); and first optical
means (26) for producing an image of the first object (12)
in an image plane; said first means (16) being operable
for aligning an image of the first object (12) with respect
to the first reference indicium (32); said system being
characterized in that it further includes a second reference
indicium (116); second optical means (46 or 234), operable
with the first optical means (26), for producing an image
of the second reference indicium (116) in the image plane
of the first optical means (26); and third means (28, 112 &
114) for aligning the image of the second reference
indicium (116) with respect to the first reference indicium
(32); said second means (30) being operable for aligning the
second object (14) with respect to the image of the second
reference indicium (116).

2. A step-and-repeat alignment and exposure system
(10 or 160) as in claim 1 wherein said first means includes
first stage means (16) for holding the first object (12);
said second means includes second stage means (30) for
holding the second object (14); said first reference
indicium (32) is disposed on the second stage means (30);
said first stage means (16) is operable with the first
optical means (26) for aligning an image of a first portion
(42a & 42b) of the first object (12) with respect to a

-49-

first portion (39 & 40) of the first reference indicium
(32); said second stage means (30) is operable with the
first optical means (26) for aligning the second object
(14) with respect to an image of the first object (12)
and for aligning a second portion (39) of the first
reference indicium with respect to an image of a second
portion (88) of the first object (12); said third means
includes adjustment means (28, 112 & 114), operable with
the first and second optical means (26 & 46 or 234), for
aligning the image of the second reference indicium (116)
with respect to a third portion (41) of the first reference
indicium (32); and said second stage means (30) is also
operable with the first and second optical means (26 &
46 or 234) for aligning the second object (14) with
respect to the image of the second reference indicium (116).

3. A step-and-repeat alignment and exposure system
(160) for aligning first and second objects (12 & 14),
said system including first stage means (16) for holding
the first object (12); second stage means (30), disposed
on one side of the first stage means (16), for holding the
second object (14); and a reference indicium (32) disposed
on the second stage means (30); said system being characterized
in that it further includes source means (164), disposed on
the other side of the first stage means (16), for providing
illumination and exposure light; said source means (164)
including shutter means (190) operable in a closed position
for enabling the source means (164) to provide the illumination light and operable in an open position for enabling the
source means (164) to provide the exposure light; objective
optical means (214, 216a & 216b), disposed on said other side of the first stage means (16), for viewing an image of the first and second objects (12 & 14); imaging optical means (200), disposed between the first stage means (16) and both the source means (164) and objective optical means (214, 216a & 216b), for imaging the illumination and exposure light from the source means (164) at the first object (12) to illuminate portions of the first object (12); and projection optical means (26), disposed between the first and second stage means (16 & 30), for projecting an image of the illuminated portion of the first object (12) to the second object (14); said imaging optical means (200) being operable with the projection optical means (26) for imaging reflected illumination light from the second object (14) at the objective optical means (214, 216a & 216b).

Fig 1

0098984

1/6

0098984

2/6

Fig 2

Fig 3

Fig 4A

Fig 4B

Fig 5

Fig 7

Fig 6

Fig 8A

Fig 8B

142 or 248

116

141

54 or 250

$$\underline{\text{Fig}}\quad 9$$

142 or 248

116

76a, 76b
or 78

54 or 250

$$\underline{\text{Fig}}\quad 10$$

Fig 11A

Fig 11B

0098984

European Patent Office

**EUROPEAN SEARCH REPORT**

Application number

EP 83 10 5812

## DOCUMENTS CONSIDERED TO BE RELEVANT

| Category | Citation of document with indication, where appropriate, of relevant passages | Relevant to claim | CLASSIFICATION OF THE APPLICATION (Int. Cl. 3) |
|---|---|---|---|
| A | US-A-4 311 390 (E.H. PHILLIPS) * Abstract * | 1-3 | G 03 B 41/00 |
| A | EP-A-0 036 026 (OPTIMETRIX CORP.) * Abstract * | 1-3 | |
| A | EP-A-0 027 570 (OPTIMETRIX CORP.) * Abstract * | 1-3 | |

| | TECHNICAL FIELDS SEARCHED (Int. Cl. 3) |
|---|---|
| | G 03 B 41/00<br>G 03 F 9/00<br>G 05 D 3/00<br>H 01 L 21/00<br>H 01 L 23/00<br>G 02 B 19/00 |

The present search report has been drawn up for all claims

| Place of search | Date of completion of the search | Examiner |
|---|---|---|
| THE HAGUE | 02-09-1983 | PRATSCH H.R. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO Form 1503 03 82